# EUROPEAN PATENT APPLICATION

(11) **EP 1 069 614 A2**
(43) Date of publication of application: **17.01.2001**
(21) Application number: 00305834.4
(22) Date of filing: 12.07.2000
(51) Int. Cl.: H01L 21/8247, H01L 27/105

(54) **Method of fabricating an integrated circuit**

(30) Priority: 14.07.1999 US 143796 P
(71) Applicant: Texas Instruments Incorporated, Dallas, Texas 75251 (US)
(72) Inventor: Mehrad, Freidoon, Plano, Texas 75023 (US); Xia, Jie, Plano, Texas 75024 (US); Ambrose, Thomas M., Richardson, Texas 75081 (US)
(74) Representative: Legg, Cyrus James Grahame

(57) **Abstract**

A method to implant NMOS polycrystalline silicon in embedded FLASH memory applications is described. In the method the polycrystalline silicon region (130) that will used to form the gate electrode of the NMOS transistor is doped simultaneously along with the source line in the FLASH memory array.

## Description

This invention relates to the field of electronic devices and more especially to a method for fabricating an embedded FLASH memory circuit.

Electronic equipment such as televisions, telephones, radios, and computers are constructed using semiconductor components, such as integrated circuits, memory chips, and the like. Semiconductor components are constructed from various microelectronic devices fabricated on a semiconductor substrate, typical microelectronic devices including transistors, capacitors, diodes, resistors and the like. Each microelectronic device includes a pattern of conductor, semiconductor and insulator regions formed on the semiconductor substrate.

The density of the microelectronic devices on the semiconductor substrate may be increased by decreasing the spacing between the semiconductor devices. This decrease in spacing allows a larger number of the microelectronic devices to be formed on the semiconductor substrate, a result of which is that the computing power and speed of the semiconductor component may be greatly improved.

FLASH memory, also known as FLASH EPROM or FLASH EEPROM, is a semiconductor component that is formed from an array of memory cells each of which includes a floating gate transistor. Data can be written to each cell within the array, but the data is erased in blocks of cells. Each cell includes a floating gate transistor having a source, drain, floating gate and a control gate. The floating gate uses channel hot electrons for writing from the drain and uses Fowler-Nordheim tunneling for erasure from the source. The sources of the floating gate transistors in the cells in each row of the array are connected together to form a source line.

Embedding FLASH memory circuits in CMOS logic circuits (embedded FLASH) is finding increasing use in building more complex integrated circuits such as digital signal processors for applications such as hard disk controllers. Traditionally, in CMOS integrated circuit fabrication, the polysilicon gates of both the NMOS and PMOS transistors were doped n-type with phosphorous through diffusion or ion implantation with no additional photolithography masks. The shrinking dimensions of the transistors in current use in CMOS integrated circuits have led to the gates of the NMOS transistors being doped n-type with this dopant being blocked from entering the gates of the PMOS transistors using a photolithographic pattern and masking step. The gates of the PMOS transistors are implanted p-type during the formation of the source and drain regions of the PMOS transistors. This process results in the proper threshold voltage in both the NMOS and PMOS transistors.

In the FLASH memory array, a continuous source line is used to increase circuit packing density. This continuous source line is formed using a self-aligned source (SAS) process. Here, the isolation regions between the source regions of adjacent FLASH memory cell transistors are removed using a photolithography and etch process. Photolithography is used to form a patterned resist film and the exposed oxide isolation is removed using an oxide etch process. A continuous source line is then formed using ion implantation of an n-type dopant with the photo-resist acting as an implant mask.

In the fabrication of embedded FLASH circuits, the CMOS transistors are masked during the SAS process and then processed separately after the formation of the FLASH memory cells and the continuous source line. This is mainly due to an inability to simultaneously etch doped and undoped polysilicon to form CMOS transistor gate structures. This masking and separate processing of the CMOS and FLASH portions of an embedded integrated circuit results in a complex process requiring many photolithographic masking levels which contribute to the cost to the process.

The present invention provides a method which simplifies the process of fabricating embedded FLASH integrated circuits through a reduction in the number of masking levels. Improved etching processes are also provided.

The invention provides a method of fabricating an integrated circuit which includes an embedded FLASH memory and an NMOS transistor including doping a source line region for the FLASH memory and doping a gate electrode region for the NMOS transistor during the same doping step.

One form of the method includes:
forming a photo-resist film on a semiconductor substrate in which the integrated circuit is being fabricated,
patterning the photo-resist film to expose a region which will serve as the source line region in the FLASH memory and an area of a polycrystalline silicon layer which will serve as the gate electrode region of the NMOS transistor and
simultaneously doping the exposed region and the exposed area of the polycrystalline silicon layer to provide the source line region of the FLASH memory and the gate electrode region of the NMOS transistor.

Preferably, the method includes the step of removing a plurality of isolation regions separating the source regions of the FLASH memory prior to performing the doping step during which the source line region of the FLASH memory is formed.

Preferably, the method includes:
forming a photoresist film on a semiconductor substrate in which the integrated circuit is being fabricated,
patterning the photoresist film to expose a region which will serve as a source line region for the FLASH memory and an area of a polycrystalline silicon layer which will serve as the gate electrode region of the NMOS transistor,
removing a plurality of isolation regions which separate the source regions of the FLASH memory to expose the semiconductor substrate material under the isolation regions,
simultaneously doping the exposed region and the exposed area of the polycrystalline silicon layer to provide the source line region of the FLASH memory and the gate electrode region of the NMOS transistor and
patterning and etching the polycrystalline silicon layer to form the gate electrode region for the NMOS transistor from the doped area of the polycrystalline silicon layer and a gate electrode region for a PMOS transistor from an undoped area of the polycrystalline silicon layer.

The method may further include the step of patterning and etching the polycrystalline silicon layer to form the gate electrode for the NMOS transistor from the doped area of the polycrystalline silicon layer and a gate electrode region for a PMOS transistor from an undoped area of the polycrystalline silicon layer.

Preferably, the method includes patterning and etching the polycrystalline silicon layer by steps including:
forming an anti-reflective coating film on the polycrystalline silicon layer,
forming a photoresist film on the anti-reflective coating film,
patterning and removing portions of the photoresist film to expose both doped and undoped regions of the polycrystalline silicon film,
etching the anti-reflective coating film to expose the unwanted part of the doped area of the polycrystalline silicon layer and the unwanted part of the undoped area of the polycrystalline silicon layer and
simultaneously etching the doped and undoped area of the polycrystalline silicon layer.

Preferably, etching the anti-reflective coating film includes:
effecting the flow of HBr in a plasma etcher at 85-100 sccm,
effecting the flow of O₂ in a plasma etcher at 15-20 sccm,
maintaining a plasma etcher chamber pressure of 4-8 mTorr,
maintaining a plasma etcher source power of 300-320 Watt,
maintaining a plasma etcher bias power of 110-170 Watt,
maintaining a plasma etcher cathode temperature of 55 °C;
maintaining a plasma etcher Wall/Dome Temp of 80/80 °C and
determining an etch time with a endpoint detector using a 3090Å wavelength with 35% over-etch time.

Preferably, the etching of the polycrystalline silicon layer includes:
effecting the flow of HBr in a plasma etcher at 110-140 sccm,
effecting the flow of Cl₂ in a plasma etcher at 30-60 sccm,
effecting the flow of HeO₂ in a plasma etcher at 12-19 sccm,
maintaining a plasma etcher chamber pressure of 3-7 mTorr,
maintaining a plasma etcher source power of 500-600 Watt,
maintaining a plasma etcher bias power of 25-60 Watt,
maintaining a plasma etcher cathode temperature of 55 °C,
maintaining a plasma etcher Wall and Dome Temp of 80°C and
determining an etch time with a endpoint detector using a 2880Å wavelength.

Preferably, doping is effected by a dopant selected from the group consisting of phosphorous and arsenic.

The invention provides a method of patterning and simultaneously etching doped and undoped polycrystalline silicon including:
providing a layer of polycrystalline silicon including doped and undoped regions,
forming a anti-reflective coating film on the polycrystalline silicon layer,
forming a photoresist film on the anti-reflective film,
patterning and removing portions of the photoresist film to allow access to doped and undoped regions of the polycrystalline silicon layer,
etching the anti-reflective coating film to expose unwanted doped and undoped parts of the polycrystalline silicon layer and
simultaneously etching the doped and undoped regions of said polycrystalline silicon film.

Preferably, etching the anti-reflective coating film includes:
effecting the flow of HBr in a plasma etcher at 85-100 sccm,
effecting the flow of O₂ in a plasma etcher at 15-20 sccm,
maintaining a plasma etcher chamber pressure of 4-8 mTorr,
maintaining a plasma etcher source power of 300-320 Watt,
maintaining a plasma etcher bias power of 110-170 Watt,
maintaining a plasma etcher cathode temperature of 55 °C;
maintaining a plasma etcher Wall/Dome Temp of 80/80 °C and
determining an etch time with a endpoint detector using a 3090Å wavelength with 35% over-etch time.

Preferably, etching the doped and undoped regions of said polycrystalline silicon layer includes:
effecting the flow of HBr in a plasma etcher at 110-140 sccm,
effecting the flow of Cl₂ in a plasma etcher at 30-60 sccm,
effecting the flow of HeO₂ in a plasma etcher at 12-19 sccm,
maintaining a plasma etcher chamber pressure of 3-7 mTorr,
maintaining a plasma etcher source power of 500-600 Watt,
maintaining a plasma etcher bias power of 25-60 Watt,
maintaining a plasma etcher cathode temperature of 55 °C;
maintaining a plasma etcher Wall and Dome Temp of 80 °C; and
determining an etch time with a endpoint detector using a 2880Å wavelength.

For a more complete understanding of the present invention and the advantages thereof, reference is now made to the following description taker, in conjunction with the accompanying drawings, wherein like reference numerals represent like features, in which:
FIGURES 1A to 1G are cross-sectional views representing an integrated circuit including a cell of an embedded FLASH memory, a PMOS transistor and an NMOS transistor. FIGURES 1A to 1G illustrate a simplified process, in accordance with the invention, for forming embedded FLASH integrated circuits.

Illustrated in FIGURE 1A is a portion of an integrated circuit including an embedded FLASH memory. A memory cell will be formed in region 90, a PMOS transistor in region 100, and an NMOS transistor in region 110. The substrate comprises p-type silicon 10 with regions of n-type silicon 20 in which the PMOS transistors will be formed. Both regions 10 and 20 comprise single-crystal silicon either as part of a bulk substrate wafer or as an epitaxial silicon film formed on a bulk substrate wafer. Isolation regions 30 are formed in the substrate to electrically isolate the various devices which are formed as part of the integrated circuit. These isolation regions comprise silicon dioxide and will be either shallow trench isolation (STI) structures or local oxidation structures (LOCOS). The isolation structures shown in FIGURES 1A-1G are representative of STI structures. A gate dielectric film 45 is formed over the semiconductor substrate 10 which will form part of the NMOS and PMOS transistor structure. This gate dielectric can comprise silicon oxide, silicon oxynitride, silicon nitride or any suitable material. The FLASH memory cell shown in 90 comprises an n-type drain region 72 and an n-type source region 74. The FLASH memory cell also comprises a gate dielectric film 71, a floating gate 70, an interpoly dielectric layer 60 and a control gate 50. This gate dielectric 71 can comprise silicon oxide, silicon oxynitride, silicon nitride or any suitable material The floating gate 70 and the control gate 50 may be formed using polycrystalline silicon with the control gate being n-type. The interpoly dielectric layer 60 may be formed using alternating layers of silicon dioxide (oxide) and silicon nitride (nitride) usually in the form of an oxide-nitride-oxide stacked layer. At this point in the process, the individual gates of the PMOS and NMOS transistors have not been formed and a blanket layer of polycrystalline silicon 40 covers regions 100 and 110. A layer of photo-resist 80 has been formed on the substrate which will be used for the SAS process.

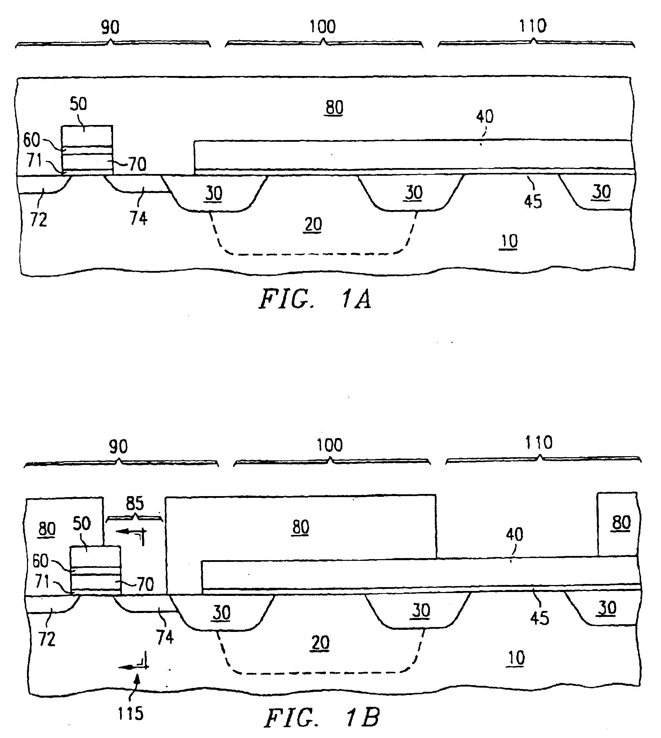

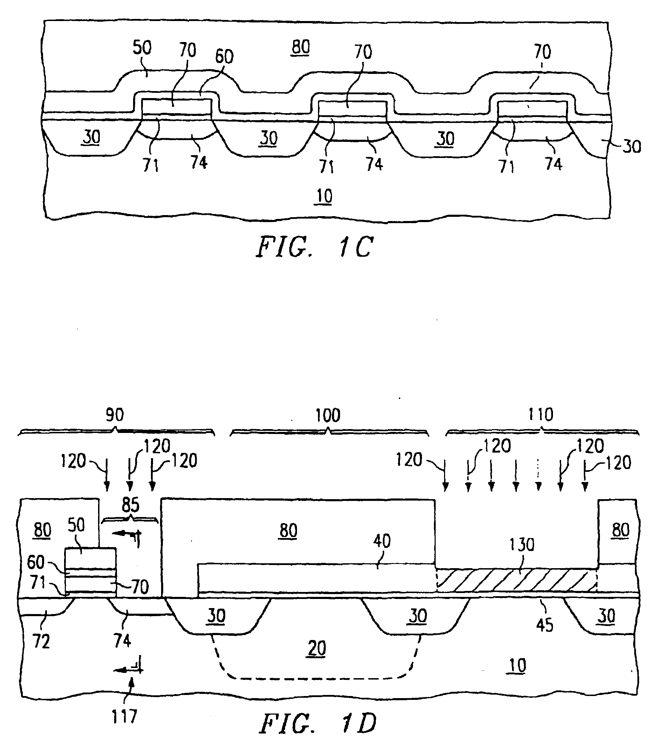

Illustrated in FIGURE 1B is the structure of FIGURE 1A after the patterning of the photo-resist layer 80 to expose the area where the source line will be formed 85 and at the same time exposing the polycrystalline silicon in region 110 where the NMOS transistor will be formed. This is in contrast to previous processes where the polycrystalline silicon which will be used to form the gate of the NMOS transistor is not exposed at this point. Using the previous processes, additional process steps will have to be performed to form the NMOS and PMOS gate electrodes as well as implant n-type dopant ions into the gate of the NMOS transistor. These additional process steps add complexity and cost to the overall embedded FLASH process. Shown in Figure 1C is a cross-section of the structure shown in Figure 1B in the direction illustrated by 115. This shows the continuous word line 50 and the isolation structures 30 that will be removed to form the self aligned source (SAS) region.

Shown in FIGURE 1D is the structure of FIGURE 1B after the isolation oxide etch and n-type dopant implantation. The isolation oxide etch will remove all of the isolation oxide exposed in the region 85 that forms a continuous line with the source region 74 and extends both into and out of the plane of FIGURE 1D. The is illustrated in Figure 1E which shows a cross-section in the plane 117 illustrated in Figure 1D. As shown in Figure 1E, the isolation material in the trenches 30 has been removed during the SAS etch process exposing the silicon substrate 10. As shown in Figure 1D, the implantation of the n-type dopant 120 will result in the simultaneous formation of the source line in the FLASH memory array and the n-type region 130 of the polycrystalline silicon film 40 which will be used to form the gate electrode of the NMOS transistor. This n-type dopant 120 may comprise phosphorous ions or arsenic ions or a combination of both. As shown in Figure 1E, the implantation of the n-type dopant results in the formation of the continuous source line 77. As shown in Figure 1D, the portion of the polycrystalline film in region 100 was masked from the implant by the photo-resist layer 80 and will be used to form the gate of the PMOS transistor. This process will result in a reduction in the number of masking steps when compared with conventional processes where the source line formation and the doping of the polycrystalline silicon region 130 used to form the NMOS gate electrode are performed in separate steps. During the isolation oxide etch, the thickness of the polycrystalline film in the region 130 will be reduced by about 50Å to 200Å depending on the etch process used. After the implantation of the n-type dopant 120 and any additional processes, the resist film 80 is removed and a new photo-resist layer 140 is formed and patterned to mask the FLASH memory cell and expose the areas of the polycrystalline film 40 which will be etched away to form the gate electrodes of the NMOS and PMOS transistors.

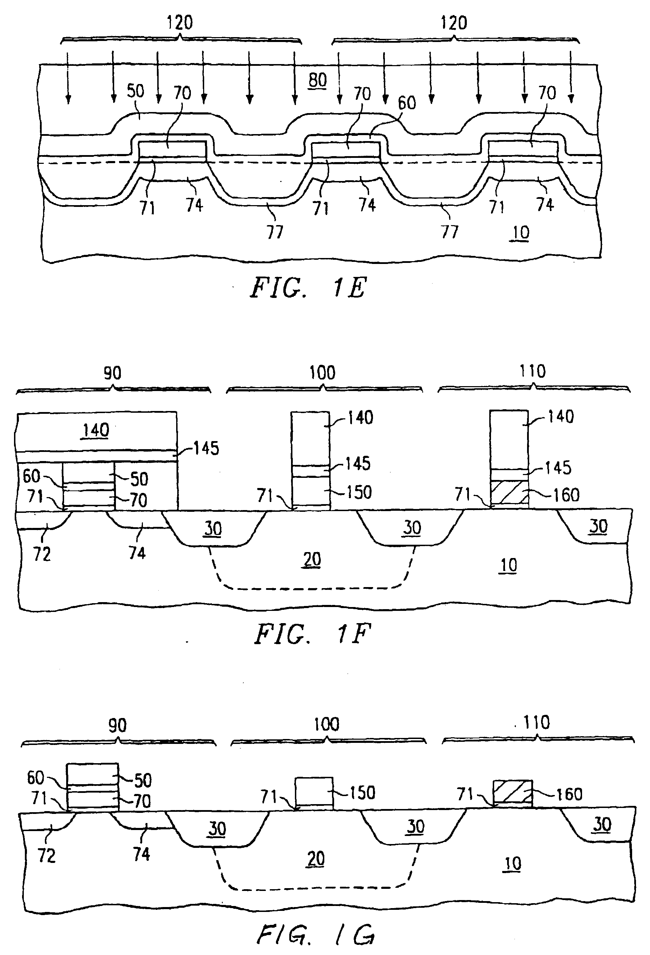

Illustrated in FIGURE 1F is the structure after the polycrystalline silicon etch process showing the NMOS transistor gate electrode 160 and the PMOS transistor gate electrode 150. The etch process used to form the gate electrodes 150 and 160 should possess the property of being able to form lines 0.07um to 0.5um in width in both doped and undoped polycrystalline silicon simultaneously. The ability of the polysilicon etch process to etch both doped and undoped polysilicon to ultra fine linewidths is an advantage of the present invention. A suitable etch process for forming the gate electrodes 150 and 160 (ie., simultaneously etching doped an undoped polysilicon) in an embodiment of the present invention will now be described. In this example the resist layer 140 comprises a 6000Å - 8000Å deep ultraviolet (DUV) photo-resist film and overlies a 1300Å - 1700Å deep ultraviolet (DUV) anti-reflective coating (BARC) 145. Following the isolation oxide etch process, the doped polycrystalline film will be about 2500Å thick and the undoped polycrystalline film will be about 2600Å thick. The gate dielectric layer 45 under the polycrystalline layer will be about 38Å thick. The process will be performed in an etch chamber with a Decoupled Plasma Source and comprises an in-situ BARC and polycrystalline etch process with the following steps:

### a) BARC Etch

- HBr: 85-100 sccm
- O₂: 15-20 sccm
- Pressure: 4-8 mTorr
- Source power: 300-320 Watt
- Bias power: 110-170 Watt
- Cathode Temp: 55 °C
- Wall/Dome Temp: 80/80 °C
- Etch Time: Endpoint (3090Å wavelength) with 35% over-etch time

### b) Poly Breakthrough Etch

- CF₄: 30-60 sccm
- Pressure: 3-7 mTorr
- Source power: 400-800 Watt
- Bias power: 25-60 Watt
- Cathode Temp: 55 °C
- Wall/Dome Temp: 80/80 °C
- Etch Time: 10 s

### c) Poly Main Etch (Bulk step)

- HBr: 110-140 sccm
- Cl₂: 30-60 sccm
- HeO₂: 12-19 sccm
- Pressure: 3-7 mTorr
- Source power: 500-600 Watt
- Bias power: 25-60 Watt
- Cathode Temp: 55 °C
- Wall/Dome Temp: 80/80 °C
- Etch Time: 50 s

### d) Poly Endpoint Etch

- HBr: 130-170 sccm
- Cl₂: 60-80 sccm
- HeO₂: 15-20 sccm
- Pressure: 8-15 mTorr
- Source power: 300-450 Watt
- Bias power: 50 Watt
- Cathode Temp: 55 °C
- Wall/Dome Temp: 80/80 °C
- Etch Time: Endpoint (2880Å wavelength)

### e) Poly Over Etch

- HBr: 130-170 sccm
- HeO₂: 9-13 sccm
- Pressure: 90-120 mTorr
- Source power: 700-900 Watt
- Bias power: 100-250 Watt
- Cathode Temp: 55 °C
- Wall/Dome Temp: 80/80 °C
- Etch Time: 65 s

The BARC etch is designed to have smaller etch biases. The Poly etch is designed to have less doped and undoped differences to increase margins for the n-type polycrystalline region 103 recess (∼100Å) due to SAS isolation etch process.

Illustrated in FIGURE 1G is the structure of FIGURE 1F after removal of the resist film 140 and the BARC film 145. The embedded FLASH integrated circuit will be completed using standard semiconductor processing.

While this invention has been described with reference to illustrative embodiments, this description is not intended to be construed in a limiting sense. Various modifications and combinations of the illustrative embodiments, as well as other embodiments of the invention will be apparent to persons skilled in the art upon reference to the description. It is therefore intended that the appended claims encompass any such modifications or embodiments.

## Claims

1. A method of fabricating an integrated circuit which includes an embedded FLASH memory and an NMOS transistor, including doping a source line region for the FLASH memory and doping a gate electrode region for the NMOS transistor during the same doping step.

2. A method as claimed in claim 1 including:
forming a photo-resist film on a semiconductor substrate in which the integrated circuit is being fabricated,
patterning the photo-resist film to expose a region which will serve as the source line region in the FLASH memory and an area of a polycrystalline silicon layer which will serve as the gate electrode region of the NMOS transistor and
simultaneously doping the exposed region and the exposed area of the polycrystalline silicon layer to provide the source line region of the FLASH memory and the gate electrode region of the NMOS transistor.

3. A method as claimed in claim 1 or claim 2, including the step of removing a plurality of isolation regions separating the source regions of the FLASH memory prior to performing the doping step during which the source line region of the FLASH memory is formed.

4. A method as claimed in claim 1, including:
forming a photoresist film on a semiconductor substrate in which the integrated circuit is being fabricated,
patterning the photoresist film to expose a region which will serve as a source line region for the FLASH memory and an area of a polycrystalline silicon layer which will serve as the gate electrode region of the NMOS transistor,
removing a plurality of isolation regions which separate the source regions of the FLASH memory to expose the semiconductor substrate material under the isolation regions,
simultaneously doping the exposed region and the exposed area of the polycrystalline silicon layer to provide the source line region of the FLASH memory and the gate electrode region of the NMOS transistor and
patterning and etching the polycrystalline silicon layer to form the gate electrode region for the NMOS transistor from the doped area of the polycrystalline silicon layer and a gate electrode region for a PMOS transistor from an undoped area of the polycrystalline silicon layer.

5. A method as claimed in any one of claims 1 to 3, further including the step of patterning and etching the polycrystalline silicon layer to form the gate electrode for the NMOS transistor from the doped area of the polycrystalline silicon layer and a gate electrode region for a PMOS transistor from an undoped area of the polycrystalline silicon layer.

6. A method as claimed in claim 5, including patterning and etching the polycrystalline silicon layer by steps including:
forming an anti-reflective coating film on the polycrystalline silicon layer,
forming a photoresist film on the anti-reflective coating film,
patterning and removing portions of the photoresist film to expose both doped and undoped regions of the polycrystalline silicon film,
etching the anti-reflective coating film to expose the unwanted part of the doped area of the polycrystalline silicon layer and the unwanted part of the undoped area of the polycrystalline silicon layer and
simultaneously etching the doped and undoped area of the polycrystalline silicon layer.

7. A method as claimed in claim 6, wherein etching the anti-reflective coating film includes:
effecting the flow of HBr in a plasma etcher at 85-100 sccm,
effecting the flow of O₂ in a plasma etcher at 15-20 sccm,
maintaining a plasma etcher chamber pressure of 4-8 mTorr,
maintaining a plasma etcher source power of 300-320 Watt,
maintaining a plasma etcher bias power of 110-170 Watt,
maintaining a plasma etcher cathode temperature of 55 °C;
maintaining a plasma etcher Wall/Dome Temp of 80/80 °C and
determining an etch time with a endpoint detector using a 3090Å wavelength with 35% over-etch time.

8. A method as claimed in any one of claims 4 to 7 wherein the etching of the polycrystalline silicon layer includes:
effecting the flow of HBr in a plasma etcher at 110-140 sccm,
effecting the flow of Cl₂ in a plasma etcher at 30-60 sccm,
effecting the flow of HeO₂ in a plasma etcher at 12-19 sccm,
maintaining a plasma etcher chamber pressure of 3-7 mTorr,
maintaining a plasma etcher source power of 500-600 Watt,
maintaining a plasma etcher bias power of 25-60 Watt,
maintaining a plasma etcher cathode temperature of 55 °C,
maintaining a plasma etcher Wall and Dome Temp of 80°C and
determining an etch time with a endpoint detector using a 2880Å wavelength.

9. A method as claimed in any one of claims 1 to 8, wherein doping is effected by a dopant selected from the group consisting of phosphorous and arsenic.

10. A method of patterning and simultaneously etching doped and undoped polycrystalline silicon including:
providing a layer of polycrystalline silicon including doped and undoped regions,
forming a anti-reflective coating film on the polycrystalline silicon layer,
forming a photoresist film on the anti-reflective film,
patterning and removing portions of the photoresist film to allow access to doped and undoped regions of the polycrystalline silicon layer,
etching the anti-reflective coating film to expose unwanted doped and undoped parts of the polycrystalline silicon layer and
simultaneously etching the doped and undoped regions of said polycrystalline silicon film.

11. A method as claimed in claim 10, wherein etching the anti-reflective coating film includes:
effecting the flow of HBr in a plasma etcher at 85-100 sccm,
effecting the flow of O₂ in a plasma etcher at 15-20 sccm,
maintaining a plasma etcher chamber pressure of 4-8 mTorr,
maintaining a plasma etcher source power of 300-320 Watt,
maintaining a plasma etcher bias power of 110-170 Watt,
maintaining a plasma etcher cathode temperature of 55 °C;
maintaining a plasma etcher Wall/Dome Temp of 80/80 °C and
determining an etch time with a endpoint detector using a 3090Å wavelength with 35% over-etch time.

12. A method as claimed in claim 10 or claim 11, wherein etching the doped and undoped regions of said polycrystalline silicon layer includes:
effecting the flow of HBr in a plasma etcher at 110-140 sccm,
effecting the flow of Cl₂ in a plasma etcher at 30-60 sccm,
effecting the flow of HeO₂ in a plasma etcher at 12-19 sccm,
maintaining a plasma etcher chamber pressure of 3-7 mTorr,
maintaining a plasma etcher source power of 500-600 Watt,
maintaining a plasma etcher bias power of 25-60 Watt,
maintaining a plasma etcher cathode temperature of 55 °C;
maintaining a plasma etcher Wall and Dome Temp of 80 °C; and
determining an etch time with a endpoint detector using a 2880Å wavelength.
